# EUROPÄISCHE PATENTSCHRIFT

(11) **EP 1 394 931 B1**
(45) Veröffentlichungstag und Bekanntmachung des Hinweises auf die Patenterteilung: **31.12.2014**
(21) Anmeldenummer: 03400023.2
(22) Anmeldetag: 16.05.2003
(51) Int. Cl.: H04L 27/04, H04B 1/04, H04B 14/02, H03C 1/36

(54) **Verfahren und Vorrichtung zum Erzeugen und diskontinuierlichen Senden einer Grundschwingung in einer vorbestimmten Trägerfrequenz**
Method and device for producing and sending discontinuoulsy a fundamental frequency in a predetermined carrier frequency
Méthode et dispositif pour produire et émettre de façon discontinue une fréquence fondamentale dans une fréquence porteuse prédeterminée

(30) Priorität: 23.08.2002 DE 10238711
(43) Veröffentlichungstag der Anmeldung: 03.03.2004
(73) Patentinhaber: Valeo Schalter und Sensoren GmbH, 74321 Bietigheim-Bissingen (DE)
(72) Erfinder: Künzler, Frank, 76703 Kraichtal (DE)

(56) Entgegenhaltungen:
- EP-A2- 0 496 498
- US-A- 2 470 573
- US-A- 3 297 963
- US-A- 4 599 582

## Beschreibung

Die vorliegende Erfindung betrifft ein Verfahren sowie eine dieses umsetzende Vorrichtung zum Erzeugen und diskontinuierlichen Senden einer Grundschwingung in einer vorbestimmten Trägerfrequenz, vorzugsweise in einem Hochfrequenzsystem, bei dem Schwingungen im Bereich von mehreren kHz zur Anwendung kommen. Derartige Verfahren sind beispielsweise aus der US 3 297 963 A und der US 4 559 582 A vorbekannt.

Bekannte Frequenzsysteme umfassen beispielsweise Radarsysteme oder Kommunikationssysteme, wobei Schwingungen von < 1 Hz bei zum Beispiel Schall bis zu TH_{z} bei zum Beispiel Licht eingesetzt werden. Für Radaranwendungen ist eine Frequenz zwischen 2 GH_{z} und 100 GH_{z} vorteilhaft. Der automotive Radarbereich ist bei ca. 24 GH_{z} und 76 bis 77 GH_{z} angesiedelt. Dabei wird eine Grund- oder Trägerfrequenz definiert, moduliert und ausgesendet. In der Regel kommt hier ein Oszillator zum Einsatz, der beispielsweise bei einer Pulsradarvorrichtung Schwingungen im Bereich von 24 GHz erzeugt. Mittels eines dem Oszillator nachgelagerten Schalters bzw. Modulators erfolgt das Modulieren der Schwingung, das heißt, diese wird in definierte Sendephasen und Sendepausen unterteilt, bevor diese an eine Übertragungsantenne zu Zwecken der Aussendung der Signalschwingung weitergeleitet werden.

Es ist jedoch eine Eigenschaft in Hochfrequenzsystemen, wie beispielsweise bei dem oben genannten Pulsradarsystem, dass der Modulator bzw. Schalter nur eine endliche Isolation bewerkstelligen kann, was dazu führt, dass das System selbst während der Sendepausen ein Signal aussendet, was selbstverständlich unerwünscht ist.

Man spricht von einer sogenannten Dauersendung des Trägers ("CW-Leakage"). Das dabei stets ausgesendete Signal weist eine um den Faktor der Isolation des Modulators verringerte Amplitude auf. Dieser Effekt des "CW-Leakage" führt im Frequenzbereich im Nachfolgenden zu einem Ausschlag bzw. "Peak" mit einer erhöhten Amplitude bzw. erhöhten Leistung.

Aufgrund dieser Tatsache ergeben sich unter anderem Probleme mit der Zulassung, da die überhöhte und damit quasi nutzlos emittierte Leistung bei der Trägerfrequenz inakzeptabel ist. In diesem Zusammenhang wird auch die überhöhte Leistung bei den harmonischen Schwingungen als sehr kritisch angesehen.

Insgesamt zeichnen sich die Systeme durch eine schlechtere Leistung dahingehend aus, dass dieses permanent vorhandene, vor allem während der Sendepausen in Erscheinung tretende Störsignal auf Seiten des Empfängers den Rauschpegel erhöht. Als weiterer besonderer Nachteil hat sich herausgestellt, dass aufgrund dieser Störsignale insbesondere bei den hochsensiblen Hochfrequenzsystemen, wie beispielsweise Radar, eine Interferenz mit anderen Systemen auftritt, was selbstverständlich unerwünscht ist. Ein weiteres schlechtes Leistungsmerkmal ist in dem durch das Störsignal bedingten Empfang von unerwünschten Dopplersignalen zu sehen.

Aus dem Stand der Technik ist es hinlänglich bekannt, den vorhergehend geschilderten Nachteilen dahingehend zu begegnen, dass die Isolation des Modulators stets verbessert wird, indem entsprechende Schaltungen vorgesehen werden, die zu einer Erhöhung der Isolation führen. Selbstredend ist so etwas mit einem enormen technischen Aufwand verbunden, was sich nachteilig auf die Kosten auswirkt.

Ausgehend davon ist es die Aufgabe der vorliegenden Erfindung, für ein Frequenzsystem ein technisch einfaches und kostengünstiges Verfahren und eine dieses implementierende Vorrichtung vorzusehen, mit der auf einfache Weise ein Störsignal während der Sendepausen unterdrückt werden kann.

Gelöst wird diese Aufgabe mit einem Verfahren nach Anspruch 1 sowie einer Vorrichtung nach Anspruch 7.

Ein wesentliches Merkmal der Erfindung liegt darin, dass die Grundschwingung, die eine vorbestimmte Trägerfrequenz aufweist, so getaktet wird, dass diese während der Sendephasen erzeugt und ausgesendet werden kann. Mit anderen Worten, die Grundschwingung wird in entsprechenden vordefinierten Zeitfenstern periodisch eingeschaltet und wieder ausgeschaltet. Diese Zeitfenster korrelieren dabei im Wesentlichen mit den durch den Modulator vorgegebenen Sendephasen und Sendepausen. Durch derartiges temporäres Abschalten der die Grundschwingung erzeugenden Signalquelle kann die Dauersendung ("CW-Leakage") eines Störsignals des Trägers weitestgehend verringert werden, wobei sich gezeigt hat, dass sich durch ein derart einfaches Takten vergleichbare Ergebnisse erzielen lassen, wie sie mit der technisch wesentlich aufwändigeren Erhöhung der Isolation des Modulators bewerkstelligt werden.

Ein anderes wesentliches Merkmal der Erfindung liegt darin dass das Takten jeweils vor dem Modulieren durch Einschalten der Signalquelle beginnt und nach dem Modulieren durch Ausschalten der Signalquelle endet.

Gemäß der Erfindung wird ein derartiges Verfahren durch eine Vorrichtung eines Frequenzsystems bewerkstelligt, indem eine Steuereinheit mit dem die Grundschwingung erzeugenden Oszillator gekoppelt ist, derart, dass diese den Oszillator in den vorgesehenen definierten Zeitabständen taktet, so dass die Grundschwingung in der Sendephase des Frequenzsystems wie sie durch den Modulator dieses Systems bestimmt werden, erzeugt wird, wobei der Oszillator eingeschaltet wird, bevor der Modulator eingeschaltet wird, und ausgeschaltet wird, nachdem der Modulator ausgeschaltet wurde.

Gemäß der Erfindung ist es möglich, dass das Takten der Signalquelle in unterschiedlichen Modi erfolgt.

In einer Ausführungsform der Erfindung wird die Signalquelle, je nach Frequenzsystem, für jeden Puls oder "Burst" ein- und wieder ausgeschaltet.

In einer anderen Ausführungsform erfolgt das Takten der Signalquelle beispielsweise für jeden "Code" bzw. Messzyklus oder "Sweep".

In der Regel besteht eine Signalquelle für Frequenzanwendungen, uns insbesondere für Hochfrequenzanwendungen, aus zumindest einem Oszillator, der wiederum sogenannte aktive, verstärkende Elemente und ein Rückkoppelnetzwerk aufweist. Das sogenannte aktive, verstärkende Element wird in der Regel, je nach Aufbau integriert oder diskret, aus einem oder mehreren Transistoren gebildet. Hierbei werden für Frequenzen der Grundschwingung über 15 GHz sogenannte FET("Feldeffekt") - Transistoren eingesetzt.

Gemäß einer Ausführungsform der Erfindung, bei der das Hochfrequenzsystem Transistoren aufweist, lässt sich durch Verändern von zumindest einer Bias-Spannung die Verstärkung des Transistors variieren, da in der Regel die Verstärkung und der Arbeitspunkt des Transistors durch zwei Bias-Spannungen eingestellt werden. Im Extremfall lässt sich dadurch die Verstärkung auf Null reduzieren, so dass der gesamte Oszillator durch ein Variieren der Bias-Spannungen ein- und ausgeschaltet bzw. getaktet werden kann. Mit anderen Worten, die Variation der Bias-Spannung erfolgt in den Sendepausen stets so, dass die Verstärkung des Transistors während der Sendepausen ausgeschaltet wird.

In einer weiteren Ausführung der Erfindung wird bei der Verwendung von FET-Transistoren das Takten dadurch bewerkstelligt, dass jede Verstärkung oder Oszillation durch Anlegen einer Spannung am Gate des FET-Transistors in Höhe der Abschnürspannung bzw. sogenannten "Pinch-off"-Spannung gestoppt werden kann. Hierbei wird durch Umschalten zwischen der "Pinch-off"-Spannung und der Spannung für einen normalen Betrieb der Oszillator an- und abgeschaltet.

Ausgehend von den vorherigen Ausgestaltungen wird deutlich, dass sich ein "Schalter", der erfindungsgemäß als Steuereinheit konzipiert ist, auf einfachste Weise durch herkömmliche Transistoren realisieren lässt, wobei in der Praxis je nach Anforderungen verschiedene Schaltungen zur Anwendung kommen können.

Ein derart gemäß der Erfindung getaktetes Frequenzsystem eignet sich besonders zur Verwendung in Radarsystemen oder Kommunikationssystemen oder Datenfernübertragungssystemen.

Im Folgenden soll die Erfindung anhand von unter Bezugnahme auf die beiliegenden Zeichnungen erläuterten Ausführungsbeispielen näher beschrieben werden. Es zeigen:
- Figur 1:: schematisch einen Vergleich zwischen einem idealen Signal und einem realen Signal, welches ein Störsignal beinhaltet, nach dem Stand der Technik;
- Figur 2:: schematisch die Gegenüberstellung der Signalverläufe gemäß einem ersten Ausführungsbeispiel der vorliegenden Erfindung;
- Figur 3:: eine Gegenüberstellung der Signalverläufe für ein zweites Ausführungsbeispiel der Erfindung; und
- Figur 4:: schematisch den Aufbau eines erfindungsgemäßen Hochfrequenzsystems.

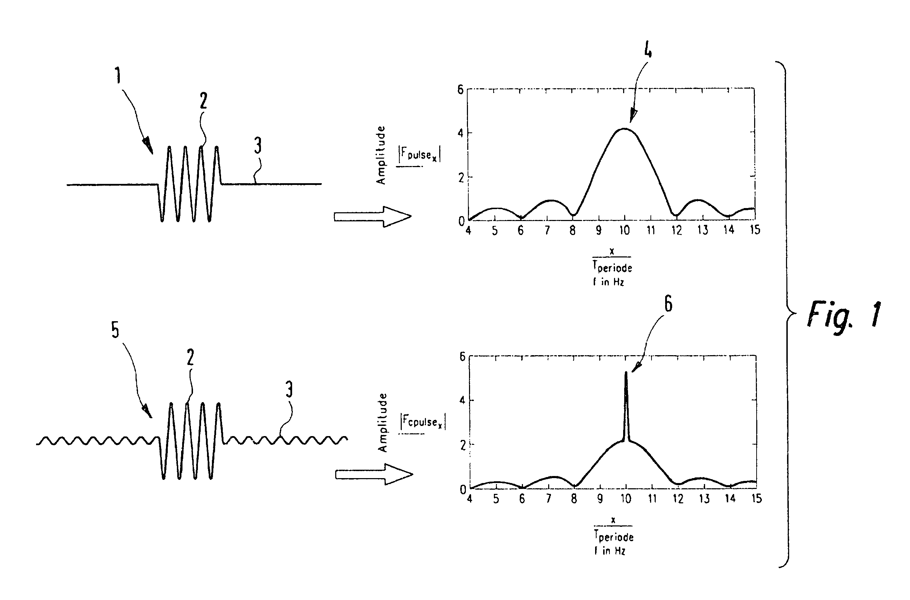

Figur 1 zeigt schematisch eine Gegenüberstellung eines Signalverlaufs eines theoretischen idealen Signals einerseits und eines realen Signals andererseits, wie es üblicherweise in bekannten Hochfrequenzsystemen in Erscheinung tritt.

Ein ideales Signal 1 wird nur während der Sendephase 2 oszillieren, während der Sendepausen 3 jedoch keinerlei Oszillationen zeigen. Ein derartiges ideales Signal 1 würde theoretisch einen idealen Amplitudenverlauf wiedergeben, wie er exemplarisch in der rechten Seite der Figur 1 gezeigt ist, wobei während der Sendephase 2 eine entsprechende Amplitudenerhöhung 4 auftritt.

In der Realität ergibt sich jedoch ein anderer Signalverlauf und damit einhergehend ein anderes Spektrum des Frequenzbereichs des Signals. Ein reales Signal 5 oszilliert während der Sendephase 2 entsprechend der vorgegebenen Erregung. Jedoch zeigt das Signal 5 auch während der Sendepausen 3 eine bestimmte Oszillation, allerdings mit erniedrigter Amplitude. Dies ist wiederum in der rechtsseitigen Darstellung in Figur 1 zu erkennen. Das während der Sendepause 3 oszillierende reale Signal 5 wird als "CW-Leakage" bezeichnet und führt im Amplitudenspektrum zu einem Peak 6 erhöhter Leistung.

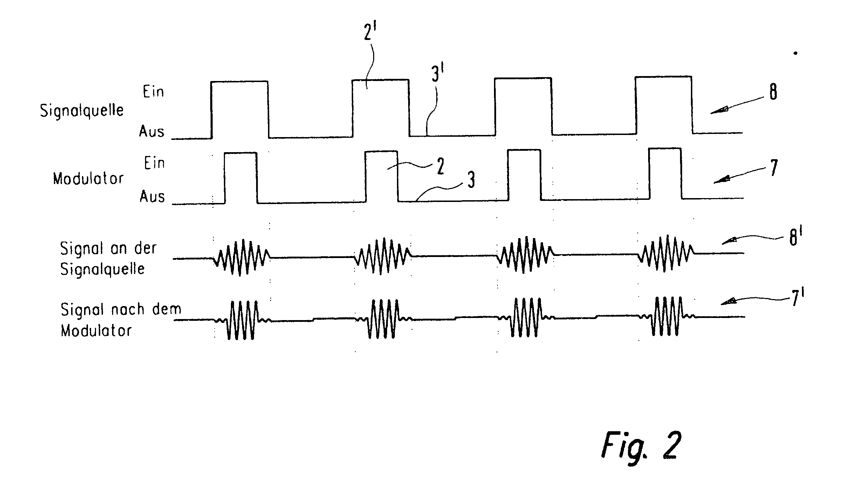

In Figur 2 ist ein erstes Ausführungsbeispiel des erfindungsgemäßen Verfahrens gezeigt, wobei das Hochfrequenzsystem ein pulsmoduliertes System ist, bei welchem gemäß der Erfindung der Oszillator bzw. die Signalquelle für jeden Puls ein- und wieder ausgeschaltet wird.

In dieser Figur 2 sind die Taktraten der Signalquelle und des Modulators den sich daraus ergebenden Signalverläufen jeweils gegenübergestellt. Die Taktrate des Modulators ergibt sich aus dem Verlauf 7, wodurch sich definierte Zeitfenster in Form der Sendephasen 2 und Sendepausen 3 einstellen. Gemäß der Erfindung wird die Signalquelle im Wesentlichen in den gleichen Zeitabständen 2, 3 getaktet, wodurch sich ein Taktratenverlauf 8 ergibt. Hierbei ist es gemäß der Erfindung vorgesehen, dass die Länge der Signalerzeugung am Oszillator etwas größer als die Länge der durch den Schalter bewirkten Sendephase 2 ist, das heißt, der Oszillator wird eingeschaltet, bevor der Modulator eingeschaltet wird, und wird ausgeschaltet, nachdem der Modulator ausgeschaltet wurde, so dass sich beim Oszillator unterschiedliche Zeitfenster 2' und 3' ergeben. In entsprechender Weise ergibt sich dann der Signalverlauf 8' in den Zeitfenstern 2', 3' an der Signalquelle einerseits und der Signalverlauf 7' in den Zeitfenstern 2, 3 nach dem Modulator andererseits, wie dieses dann letztendlich von einer Antenne ausgesendet wird.

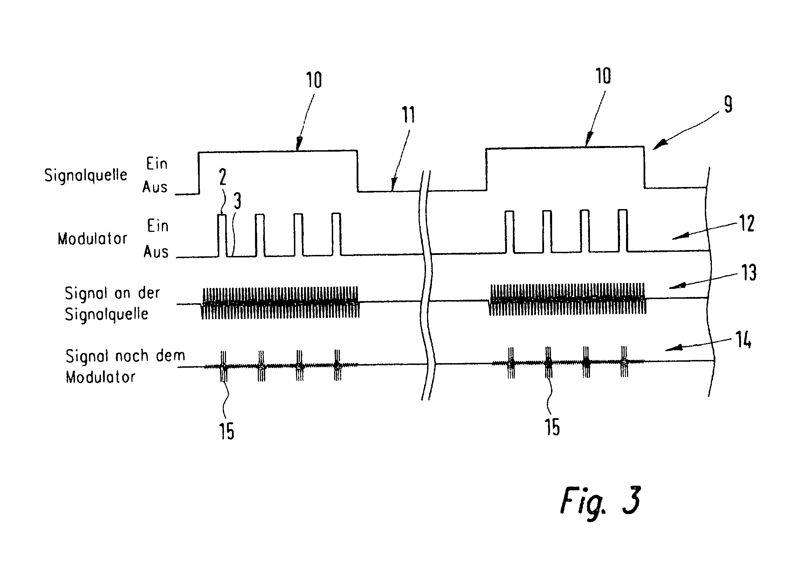

Figur 3 zeigt ein zweites Ausführungsbeispiel eines pulsmodulierten Hochfrequenzsystems, bei welchem die Signalwelle für jeden Messzyklus ein- und wieder ausgeschaltet wird. Das in Figur 3 gezeigte Ausführungsbeispiel ist typisch für Radarsysteme, bei welchen zwischen zwei Messzyklen die gemessenen Daten verarbeitet werden. Diese Signalverarbeitungszeit ist typischerweise zwischen 10- bis 100-mal länger als der Messzyklus.

Gemäß der Erfindung wird der Oszillator für den gesamten Messzyklus eingeschaltet, wodurch sich ein Taktratenverlauf 9 des Oszillators ergibt mit einem entsprechenden Zeitfenster 10 der Erregung und 11 des Stillstandes. Die Messzyklen 10 wiederholen sich periodisch.

Während eines Messzyklus 10 der Signalquelle moduliert der Schalter entsprechend den Sendephasen 2 und Sendepausen 3, so dass sich ein entsprechender Taktratenverlauf 12 ergibt. Dementsprechend stellt sich ein Signalverlauf 13 am Oszillator ein. Infolge der durch den Modulator vorgegebenen Sendephasen 2 und Sendepausen 3 ergibt sich ein Signalverlauf 14 nach dem Modulator, wobei während eines Messzyklus 10 von einer Antenne mehrere Signale 15 ausgesendet werden.

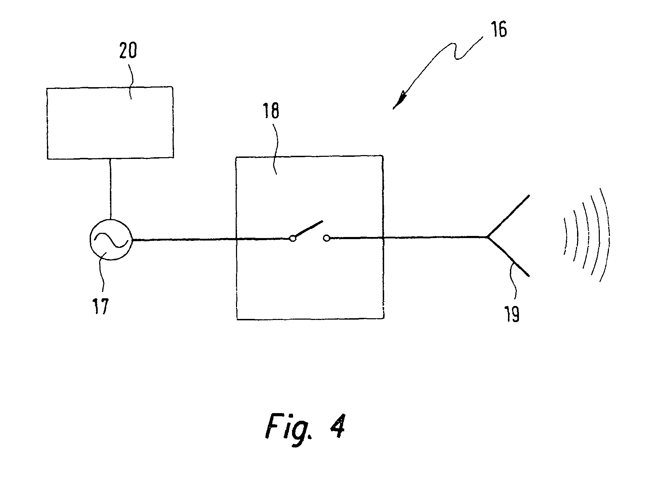

Figur 4 zeigt schematisch den Aufbau eines Hochfrequenzsystems, wie es typischerweise für Radarsysteme ausgebildet ist. Dieses Hochfrequenzsystem 16 besteht aus einem die Schwingung erzeugenden Oszillator 17, dem ein Modulator 18 nachgeschaltet ist, der das Signal in vorgegebene Zeitfenster unterteilt bzw. moduliert, um es dann von einer Antenne 19 auszusenden. Der Oszillator 17 ist mit einer Steuereinheit 20 gekoppelt, die diesen insbesondere in Korrelation mit den vom Modulator 18 vorgegebenen Zeitfenstern taktet.

## Patentansprüche

1. Verfahren zum Erzeugen und diskontinuierlichen Senden einer Grundschwingung in einer vorbestimmten Trägerfrequenz in einem Frequenzsystem, insbesondere einem Hochfrequenzsystem, wobei die Grundschwingung moduliert wird, sodass sich definierte Sendephasen und Sendepausen einstellen, wobei zur Unterdrückung eines Dauersignals ("CW-Leakage") eine Signalquelle des Hochfrequenzsystems derart getaktet wird, dass die Grundschwingung während der Sendephasen erzeugt wird und das Takten jeweils vor dem Modulieren durch Einschalten der Signalquelle beginnt und nach dem Modulieren durch Ausschalten der Signalquelle endet.

2. Verfahren nach Anspruch 1, **dadurch gekennzeichnet, dass** das Takten für jeden Puls erfolgt, wobei das Frequenzsystem pulsmoduliert ist.

3. Verfahren nach Anspruch 1, **dadurch gekennzeichnet, dass** das Takten für jeden Code bzw. Messzyklus erfolgt.

4. Verfahren nach Anspruch 2 oder 3, **dadurch gekennzeichnet, dass** bei Verwendung von Transistoren in der Signalquelle zum Takten zumindest eine Bias-Spannung der Transistoren definiert verändert wird.

5. Verfahren nach Anspruch 2 oder 3, **dadurch gekennzeichnet, dass** bei Verwendung von FET-Transistoren in der Signalquelle zum Takten eine Spannung in der Höhe einer Abschnürspannung ("Pinch-off") der FET-Transistoren angelegt wird.

6. Frequenzsystem, insbesondere Hochfrequenzsystem, zur Durchführung des Verfahrens nach einem der Ansprüche 1 bis 5, mit einer Sendeeinheit bestehend aus zumindest einem Oszillator (17), einem Modulator (18) und einer Antenne (19) zum Erzeugen und diskontinuierlichen Senden einer Grundschwingung in einer vorbestimmten Trägerfrequenz, wobei eine Steuereinheit (20) mit dem Oszillator gekoppelt ist und diesen in definierten Zeitabständen taktet, wobei der Oszillator eingeschaltet wird, bevor der Modulator eingeschaltet wird, und ausgeschaltet wird, nachdem der Modulator ausgeschaltet wurde.

7. Verwendung eines Frequenzsystems nach Anspruch 6 in einer Radarvorrichtung oder Kommunikationsvorrichtung oder Datenfernübertragungsvorrichtung.

## Claims

1. Method for producing and discontinuously sending a fundamental at a predetermined carrier frequency in a frequency system, particularly a radio-frequency system, wherein the fundamental is modulated, so that defined sending phases and sending pauses appear, wherein suppressing a continuous signal ("CW-Leakage") involves a signal source of the radio-frequency system being clocked such that the fundamental is produced during the sending phases and the clocking begins in each case before the modulation by virtue of the signal source being switched on and ends after the modulation by virtue of the signal source being switched off.

2. Method according to Claim 1, **characterized in that** the clocking is effected for each pulse, the frequency system being pulse-modulated.

3. Method according to Claim 1, **characterized in that** the clocking is effected for each code or measurement cycle.

4. Method according to Claim 2 or 3, **characterized in that** the use of transistors in the signal source prompts clocking to involve at least one bias voltage for the transistors being altered in a defined manner.

5. Method according to Claim 2 or 3, **characterized in that** the use of FET transistors in the signal source prompts clocking to involve a voltage at the level of a pinch-off for the FET transistors being applied.

6. Frequency system, particularly a radio-frequency system, for carrying out the method according to one of Claims 1 to 5, having a transmission unit comprising at least an oscillator (17), a modulator (18) and an antenna (19) for producing and discontinuously sending a fundamental at a predetermined carrier frequency, wherein a control unit (20) is coupled to the oscillator and clocks the latter at defined intervals of time, the oscillator being switched on before the modulator is switched on and being switched off after the modulator has been switched off.

7. Use of a frequency system according to Claim 6 in a radar apparatus or communication apparatus or data communication apparatus.

## Revendications

1. Procédé destiné à générer et à émettre de manière discontinue une composante fondamentale à une fréquence porteuse prédéterminée dans un système de fréquences, notamment un système à haute fréquence, dans lequel la composante fondamentale est modulée de manière à ce que des phases d'émission et des pauses d'émission définies s'établissent, dans lequel, pour supprimer un signal continu ("CW-Leakage", Fuite en onde continue), une source de signal du système à haute fréquence est cadencée de manière à ce que la composante fondamentale soit générée pendant les phases d'émission et que le cadencement commence respectivement avant la modulation par activation de la source de signal et se termine après la modulation par interruption de la source de signal.

2. Procédé selon la revendication 1, **caractérisé en ce que** le cadencement est effectué pour chaque impulsion, dans lequel le système de fréquences est modulé en impulsions.

3. Procédé selon la revendication 1, **caractérisé en ce que** le cadencement est effectué pour chaque code ou cycle de mesure.

4. Procédé selon la revendication 2 ou 3, **caractérisé en ce que**, lors de l'utilisation de transistors dans la source de signal à des fins de cadencement, au moins une tension de polarisation des transistors est modifiée de manière définie.

5. Procédé selon la revendication 2 ou 3, **caractérisé en ce que**, lors de l'utilisation de transistors FET dans la source de signal à des fins de cadencement, une tension égale à une tension de blocage ("Pinch-Off") des transistors FET est appliquée.

6. Système de fréquences, notamment système à haute fréquence, destiné à mettre en oeuvre le procédé selon l'une quelconque des revendications 1 à 5, comprenant une unité d'émission constituée d'au moins un oscillateur (17), un modulateur (18) et une antenne (19) pour générer et émettre de manière discontinue une composante fondamentale à une fréquence porteuse prédéterminée, dans lequel une unité de commande (20) est couplée à l'oscillateur et cadence celui-ci à des intervalles de temps définis, dans lequel l'oscillateur est activé avant que le modulateur soit activé, et est désactivé après que le modulateur a été désactivé.

7. Utilisation d'un système de fréquences selon la revendication 6 dans un dispositif radar ou un dispositif de communication ou un dispositif de télétransmission de données.
